Europäisches Patentamt

European Patent Office

Office européen des brevets

(19)

(11) **EP 0 415 677 B1**

(12) EUROPEAN PATENT SPECIFICATION

(45) Date of publication and mention
of the grant of the patent:
**23.06.1999 Bulletin 1999/25**

(51) Int Cl.⁶: **H04R 25/00**, H04R 3/02,
H03H 21/00

(21) Application number: **90309342.5**

(22) Date of filing: **24.08.1990**

(54) **Hearing aid having compensation for acoustic feedback**

Hörgerät mit Kompensation der akustischen Rückkopplung

Prothèse auditive avec compensation de la réaction acoustique

(84) Designated Contracting States:
**CH DE DK FR GB LI NL**

(30) Priority: **30.08.1989 GB 8919591**

(43) Date of publication of application:
**06.03.1991 Bulletin 1991/10**

(73) Proprietor: **GN DANAVOX A/S**
**DK-2630 Taastrup (DK)**

(72) Inventors:
• **Goodings, Rupert Leslie Alexander**
**Cambridge CB4 (GB)**
• **Senensieb, Gideon Abraham**
**Cambridge CB2 5QR (GB)**
• **Wilson, Philip Henderson**
**Surrey KT11 2JX (GB)**
• **Hansen, Roy Skovgaard**
**2791 Dragor, (DK)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**EP-A- 0 250 679** **EP-A- 0 339 819**
**US-A- 4 783 818**

• **ICASSP '89, vol. 3 "MULTIDIMENSIONAL
SIGNAL PROCESSING, AUDIO AND
ELECTROACOUSTICS, Glasgow, 23rd - 26th
May 1989, pages 2017-2020, IEEE, New York, US;
D.K. BUSTAMANTE et al.: "Measurement and
adaptive suppression of acoustic feedback in
hearing aids"**
• **Fischer Lexikon, Technik IV ( Elektrische
Nachrichtentechnik ), Oct.1963, pages 40,41**
• **Extracts from a thesis entitled " Digital
Suppression of Acoustic Feedback Hearing
Aids", Best L.C., University of Wyoming, USA,
May 1985, Chapters IV and VI, pages 21-31 and
44-46**

## Description

### TECHNICAL FIELD

The present invention concerns improvements in or relating to hearing aids and more particularly hearing aids such as for example "in-the-canal" (ITC), "in-the-ear" (ITE), and "behind the ear" (BTE) hearing aids which share the common feature that the microphone and receiver components thereof are mounted on a single body and are closely spaced.

A number of mechanisms can contribute to the acoustic feedback that occurs in these aids. In all cases there will occur an unavoidable acoustic or mechanical coupling through the body or the inner volume of the hearing aid. Acoustic feedback will also occur as sound is directed by reflection and is channelled from the receiver to the microphone. Thus in the case of "behind-the-ear" aids sound can be reflected by the surrounding head structures and in the case of "in-the-canal" and "in-the-ear aids" acoustic coupling can occur through an unintended aperture around the periphery of the mould of the hearing aid.

In the case of "in-the-ear" hearing aids, venting is included as a means for reducing occlusion - -that is to say, to avoid a blocked ear sensation. A further benefit of including venting is that it allows the direct input of unamplified low frequency sound into the ear - an important benefit for those patients that suffer a high frequency loss with only minor loss at low frequency and who have therefore no need for amplification in this lower frequency range. There is also available a wide range of vent sizes. Whilst larger diameter vents are more effective for reducing occlusion than vents of smaller diameter, they also give rise to an increase in acoustic feedback. Vent sizes are thus limited by the attendant need to avoid excessive acoustic feedback. Large sizes of vent now are used infrequently and are limited in application to aids using only lower gain amplification.

A number of problems are associated with acoustic feedback. The most commonly considered is the occurrence of oscillation. This occurs at high gain level and is usually persistent. At gain settings just below those that cause such oscillation "ringing effects" are perceivable. This latter causes further unpleasant sensation and reduces the intelligibility of speech and other wanted sound. An additional effect is that the acoustic feedback contributes to gain-dependent perturbations in the frequency response of the hearing aid. Such uncontrolled frequency response effects occur at gains well below the onset of oscillation and can cause quite discernable, and sometimes considerable, distortion in the perceived sound, and accordingly do reduce the effectiveness of the hearing aid in meeting prescribed characteristics.

### BACKGROUND ART

It is difficult to avoid the occurrence of acoustic feedback. Thus in the case of "in-the-ear" aids leakage can be reduced by making the ear mould a tighter fit. This however is hard to achieve and is far from ideally comfortable for the user. It is also not possible to eliminate internal acoustic feedback. In both cases however it is possible to reduce the level of acoustic feedback by careful positioning of the components, particularly the direction and position of the microphone port.

Since the elimination of acoustic feedback is not possible, effort has been directed to suppress the occurrence of oscillation. The frequency response of hearing aids means that oscillation usually occurs at frequencies in the range 1 to 4 kHz and the exact frequency is set by the normal Nyquist conditions (i.e. loop gain that is greater than zero decibels and zero phase difference between wanted signal and echo).

Oscillatory conditions may be suppressed by the user turning down the volume control, i.e. reducing gain, once oscillation has occurred. This however is generally inconvenient to the user. Therefore techniques have been developed for preventing the occurrence of oscillation. Thus the electronic gain of an aid has been reduced for frequencies where oscillation is likely to occur. This however means that the prescribed high frequency response for a deaf user would be compromised deliberately at these high frequencies which are usually in the range 1 to 4 kHz and also quite near to the natural resonant frequency of the ear canal of about 3 kHz. Also receivers have been designed to reduce their electro-acoustic gain particularly at the resonant frequency of the receiver where a relative gain figure of 10 decibels or more can occur. However, this peak is normally desirable so as to reproduce the natural canal resonances of a normal ear.

In all cases of oscillation avoidance considered above it will be noted that a design compromise is necessary and that in consequence such hearing aids can only offer a sub-optimum performance to the user.

Other corrective techniques have involved the detection of the onset of oscillation and the provision of cancellation or other compensation in response. Thus a detected signal has been used as a means of controlling an automatic gain stage. An alternative technique is to use the detected signal to control the generation of an internal oscillation and to use the latter to cancel the unwanted oscillation. This technique has to be adaptive since the oscillation frequency and amplitude will vary according to changes in external conditions. Furthermore the detected signal has been used to adjust the centre frequency of a notch filter, that is to say a filter with a frequency selective reduction in gain centered at or near the oscillation frequency.

In the above techniques involving oscillation detection however no compensation is provided for the effects of acoustic feedback at those frequencies remote from the oscillation frequency.

An alternative approach to the above is proposed in United States Patent No. 4783818. As proposed, in this reference, the effects of acoustic feedback are compensated by electrical negative feedback. The negative feedback path includes a filter the characteristics of which are modelled on those identified inter alia for the acoustic feedback path itself.

The hearing aid described in US 4783818 is constructed to have two time consecutive modes of operation: an ordinary operational mode; and an identification mode. Switching between these modes is performed by a sub-circuit that is designed to sense an initial turn-on condition and, subsequently, threshold changes in the preamplifier gain. This sub-circuit is connected across the preamplifier and includes a comparator circuit for comparing signals input to and output from the preamplifier. This comparator circuit includes RMS to DC converters to process each signal and a half-wave rectifier located between one of the converters (the one processing the input signal) and a comparator.

In the ordinary operational mode, of the above mentioned hearing aid, the compensated electrical signal is fed through an amplifier and thereon used to energise the receiver. In the identification mode, which may be selected at turn-on or in response to an automatically sensed threshold change in preamplifier gain, the amplifier is decoupled from the circuit and a correction circuit is substituted. The correction circuit includes a source of noise for example pseudo-random-binary-sequence signals and parameters associated only with acoustic feedback are identified and used to define the transfer function of the filter that is then subsequently used during ordinary operation. It is a disadvantage of this construction however that during the identification mode of operation the hearing aid behaves as a generator of acoustic noise and does not provide any effective hearing aid operation at all. Also ordinary operation is only satisfactory so long as the acoustic feedback remains substantially the same as that for which the parameters are identified. The proposed construction therefore is not entirely satisfactory for hearing aid application.

The above type of approach has also been considered experimentally, see the following thesis entitled "Digital Suppression of Acoustic Feedback in Hearing Aids" by Leland C. Best, University of Wyoming, May 1985. In this are described several experiments on an adaptive digital filter applied as a continuously adaptive feedback path to compensate for acoustic feedback in the hearing aid. Features of the hearing aid disclosed in this reference are recited in the preamble of claim 1 of the claims appended. A digital random number generator using the congruence method is employed as the source of noise which is injected into the acoustic path for deriving adaptively the filter parameters.

The experimental apparatus described in this thesis does not form a practical hearing aid. This is principally because of the problem of non-linearities in the feedback, as described in Chapters IV and VI of this reference. Such non-linearities become manifest when the output signal momentarily exceeds the linear region of the response of the output transducer. Under these circumstances the digital filter is no longer able to produce an accurate replica cancelling the feedback signals. Since the digital filter would generally be employed to enhance the gain of the hearing and, it would be quite common for both the acoustic path and the digital filter path each to be unstable when separate, only stabilising each other by producing accurate replicas of each others feedback signals. At the onset of non-linearity as described the feedback signals in the two parts no longer cancel each other and both parts become unstable. The hearing aid therefore becomes unstable, and may remain so indefinitely.

In Chapter IV of this reference, this problem is solved for experimental purposes by detecting that this situation is likely to have occurred, and silencing the transmission of output signal until this system recovers. This is performed for example by ramping down the amplifier gain to zero. See pages 26 to 28 of this reference. Such a solution would not be acceptable in practice however since it would result in fairly frequent interruptions of the amplified sound.

DISCLOSURE OF THE INVENTION

The present invention, as defined in the appended claims, is intended to provide a remedy to the problems aforesaid.

EP-A-0339819 is mentioned with reference to Articles 54(3) and 54(4) EPC. The hearing aid disclosed therein includes a logarithmic sandwich filter located in the electrical main pathway between a correlation tapping point and a noise insertion node (specifically, a logarithmic combiner). In this filter the preamplified signal is divided amongst four branch pathways by four parallel bandpass logarithmic filters, then passed through a respective limiter, and then through four parallel bandpass logarithmic postfilters and is recombined by a logarithmic combiner. Each limiter is set in compliance with a prescriptive requirement to ensure that painfully loud sounds are not emitted by the receiver. Notably, not one of the limiters is located in the electrical main pathway, as such, but in a bandwidth limited channel (branch pathway). Not one of the limiters alone is effective to ensure that at all times the linearity limits of the main amplifier and receiver are not exceeded since each operates on only one bandpass limited component of the electrical main pathway signal and not on the electrical main pathway signal as such. It is also impractical to adjust the limits of each of the four limiters so that the recombined signal at all times does not exceed the linearity limits of the main amplifier and the receiver.

EP-A-0250679 describes the use of a programmable signal limiter means interposed between the microphone and the receiver. The purpose of this limiter means is to prevent sounds amplified by the hearing aid exceeding the patient's loudness discomfort level.

The present invention as defined in claim 1 provides for practical application of feedback cancellation. The deliberate inclusion in the electrical main pathway of an amplitude limiter ensures that the output signal is prevented from reaching the non-linear region of the amplifier-receiver response. The signal input to the filter means is at all times representative of the acoustic signal emanating from the receiver. Both the acoustic path and electrical feedback pathway thus operate in their respective linear regions and non-linear oscillations are avoided. The need to interrupt the transmission of amplified sound is eliminated.

BRIEF INTRODUCTION OF THE DRAWINGS

In the drawings accompanying this specification:

Fig. 1 is a block circuit diagram of a hearing aid having provision for adaptive electrical feedback;

Fig. 2 is a block circuit diagram of adaptive components used in the above modified hearing aid;

Fig. 3 is a block circuit diagram of a hearing aid, a modification of the hearing aid shown in Fig. 1;

Fig. 4 is a block circuit diagram for an amplifier including automatic gain control;

Fig. 5 is a block circuit diagram for a limiter such as that used in the circuits of Figs. 1 and 3 above;

Figs. 6 and 7 are block circuit diagrams illustrating alternative positions for the limiter used in the aid of Figs. 1 and 3 above;

Figs. 8 and 9 are block circuit diagrams of a pseudo-random-binary-sequence generator and a variant thereof; and

Fig. 10 is a block circuit diagram of a noise level control circuit for use in the-hearing aid shown in Fig. 3.

DESCRIPTION OF THE PREFERRED EMBODIMENTS

Embodiments of the invention will now be described and reference will be made to the drawings. The description that follows is given by way of example only.

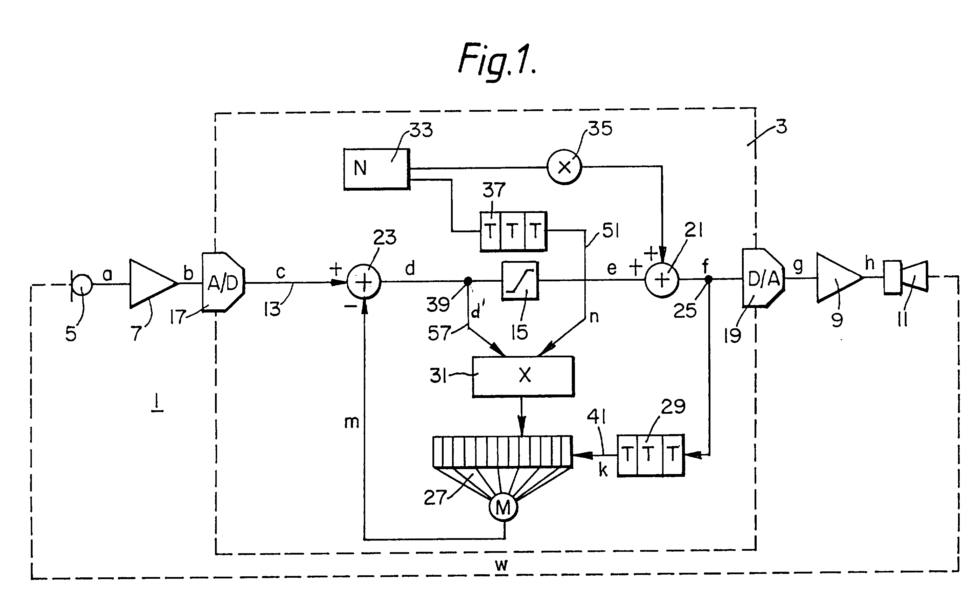

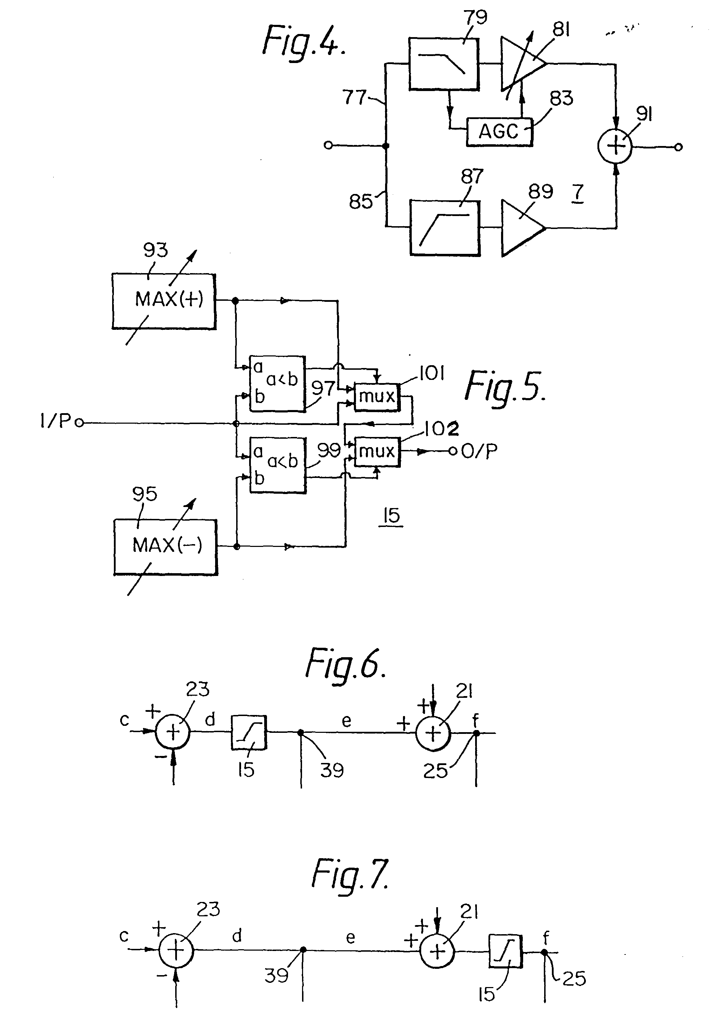

In Fig. 1 there is shown a hearing aid 1 which but for the inclusion of an adaptive circuit 3 is otherwise of conventional design and comprises an acousto-electric transducer - i.e. a miniature microphone 5 - a preamplifier 7; a main amplifier 9; and an electro-acoustic transducer - i.e. a receiver 11. The preamplifier 7 may be constructed as shown in Fig. 4 to provide a compensation for excessively loud speech signal such as that emanating from the user of the hearing aid. In one path 77 of this amplifier there is included a low pass filter 79 and a first amplifier 81. The gain of this first amplifier 81 is controlled by means of an automatic gain control circuit 83. In the other parallel path 85 of the preamplifier 7 there is included a high pass filter 87 and a second amplifier 89. The signals from each of the amplifiers 81 and 89 are summed at a summing node 91. In the connective electrical path 13 between the preamplifier 7 and the main amplifier 9 a limiter 15 is inserted so as to prevent the electrical signal reaching an amplitude level exceeding the linearity limits of each of the main amplifier 9 and the receiver 11. In the arrangement of conventional components and limiter thus far described the acousto electric gain of the microphone 5, the gain of the preamplifier 7, the gain of the main amplifier 9, and the electro-acoustic gain of the receiver 11 are all designed to have a suitable spectral response so that the insertion gain of the hearing aid conforms as near as is possible to prescriptive requirements.

For general convenience the adaptive circuit 3 has been constructed using an all digital implementation. The construction of the adaptive circuit 3 however is not restricted to the details of the design shown and mixed digital-analogue and/or analogue implementations are not precluded.

The input of the adaptive digital circuit arrangement 3 is interfaced to the preamplifier 7 by an analogue to digital converter 17. At its output the digital adaptive circuit 3 is interfaced to the main amplifier 9 by a digital-to-analogue converter 19. The limiter 15 is also of digital construction (Fig. 5) and is located in the connective path between the analogue-to-digital converter 17 and the digital-to-analogue converter 19. The signal at the input to the limiter 15 is compared in parallel by means of comparators 97 and 99 and the output signal of each of these comparators 97 and 99 is used to operate serially connected multiplexers 101 and 102. When the signal is within the set limits the signal is passed through the two multiplexers 101, 102 to the output. If however one or other of the limits is exceeded the signal is blocked and one or other of the limit value signals is passed to output by the multiplexers 101, 102. A summing node - a digital adder 21 - is interposed in the electrical connective path between the limiter 15 and the digital-to-analogue converter 19. This digital adder 21 is to provide a node (i.e. a noise insertion node) for the injection of a noise signal N as will be described hereinbelow. A subtractive node - a second digital adder 23 - is inserted in the main path between the analogue-to-digital converter 17 and the limiter 15. This latter digital adder 23 is provided as a means (i.e. a feedback insertion node) for introducing electrical feedback which also will be described hereinbelow.

The normal signal path for wanted signals from the microphone 5 to the receiver 11 is the direct path a-b-c-d-e-f-g-h as shown. It will be noted that the path elements a, b, g and h are analogue and thus provided by single conductors. Direct path elements c, d, e and f however are all digital and will thus comprise each a number of parallel conductors. Each path element could have for example between 8 and 12 parallel conductors according to the bit resolution of the analogue-to-digital converter 17.

Electrical feedback is extracted by means of a feedback tapping point 25 on section f of the main path, that is to say the section between the digital adder 21 and the digital-to-analogue converter 19, i.e. the electrical feedback signal taken from this tap includes an injected noise signal component. The tapped electrical feedback signal is passed through an adaptive filter 27, as shown here a finite impulse response (FIR) filter, and after passage through this filter 27 it is applied to the second digital adder 23. For convenience, in this arrangement the digital signal from the feedback tapping point 25 is passed through a delay line 29 before reaching the filter 27. The delay time of this line 29 is designed to model the minimum acoustic transit time between the receiver 11 and the microphone 5. The inclusion of this delay line 29 is not essential but it avoids redundancy in filter and correlator stages. The finite impulse response filter 27 is adaptively controlled by multiplicative coefficients derived using a correlator 31. The correlator 31 looks for a correlation between the injected noise signal N and any noise component in the residual signal formed at the output of the feedback insertion node, i.e. the second digital adder 23. The injected noise signal N is generated using a source 33 and is injected into the main signal path using the noise insertion node, digital adder 21, after attenuation via a multiplier 35. The noise signal is also connected to a reference input of the correlator 31 and is passed to this via a second delay line 37 which also inserts a time delay corresponding to the minimum acoustic transit time already described. The residual signal which is applied to the signal input of the correlator 31 is taken from a correlation tapping point 39 on the digital section d of the main path, that is the main path between the feedback insertion node (second digital adder) 23 and the digital limiter 15.

A copy of the electrical output signal at tap f is thus passed through the delay 29 into the adaptive Finite Impulse Response (FIR) filter 27. This filter is arranged to produce the adaptive feedback signal.

This adaptive feedback signal is subtractively summed with the input signal. In ideal operation the adaptive feedback signal will be arranged to be equal in all respects to the unwanted acoustic feedback that occurs as a result of the mechanisms described earlier (the acoustic feedback is denoted by a dotted line w in Fig. 1).

If the adaptive feedback signal and the input signal to the second digital adder 23 are equal then the output of the second digital adder 23 contains no residual feedback because the two components will exactly cancel each other.

In order to adapt the filter 27 so that it produces an exact replica of the electrical signal corresponding to the acoustic feedback, the noise signal N, after attenuation via the multiplier 35, is added to the output signal and is used to excite the receiver 11. Note that the noise signal appears in both the internal (adaptive) and external (acoustic) feedback paths, so that in ideal operation noise feedback will be completely cancelled at the second digital adder 23 so that the residual signal on lines d contain no injected noise.

It will be noted that the noise signal N injected into the main signal path at the noise insertion node 21 passes through the digital-to-analogue converter 19 and thence through the main amplifier 9 and the receiver 11. At the receiver 11 it is converted to produce an acoustic signal. This signal is superimposed upon the wanted signal. The level of the noise signal produced at the output of the multiplier 35 is therefore so chosen that the acoustic level of the output of the receiver 11 is unobtrusive to the user. Since correlative techniques are used and these are very sensitive, it is possible to use an extremely low level of noise signal, indeed one that is little higher than (i.e. within a few dB above) the white noise level of the hearing aid itself. For practical use a very efficient adaptation behaviour can be obtained by using a constant signal/noise ratio. The level of injected noise is continuously adjusted to be a certain number of dB lower than the signal and therefore unobtrusive to the ear. A high level of noise relative to the signal gives a very fast adaptation. This instantaneous signal/noise ratio can be say between 12 and 24 dB with 12 dB being suitable for persons with severe hearing losses requiring very high gain. 24 dB would result in somewhat slower adaptation, but with a noise level practically imperceptible to a person of near normal hearing requiring more moderate gain levels.

In practice, the internal (adaptive) feedback and the external (acoustic) feedback do not completely cancel and a small amount of noise (and other feedback components) appear as finite residual signal. The noise component of this residual signal is detected by the correlator 31 which usually operates continously, looking for long term agreement between the residual signal and a delayed version of the generated noise. The output of the correlator is an estimate of the residual noise in the signal, and it is used to directly adapt the filter 27. The adaption sign is choosen to adapt the filter 27 to produce lower residual noise so that the system tries to converge to a situation where the noise is cancelled. The dynamic nature of the environment, and practical algorithm limitations mean that perfect convergence is not generally achieved. However, given careful optimisation high levels of cancellation are possible.

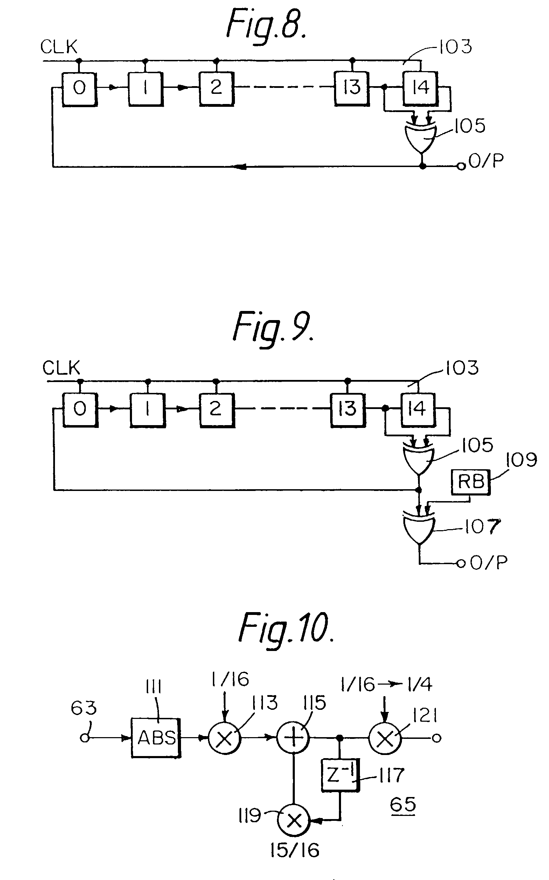

By arranging the noise to provide a satisfactory spectral characteristic, that is a flat level over a bandwidth comparable to that of the hearing aid, the adaption of a system for minimum noise components in the residual noise signal also corresponds to minimum residual feedback of all other signals. It has here been shown that pseudo-random-binary-sequence p.r.b.s. signals of appropriate bit repetition lengths can serve as satisfactory noise signal. Such pseudo-random-binary-sequence signals can be readily generated (Fig. 8) using a clocked shift register 103 with multiple feedback via an exclusive OR-gate 105. Such configured registers produce signals with a pattern repeating after every $2^M$ -1 bits where M denotes the number of register stages. Satisfactory performance has been obtained for sequences of length 127 bits and 37267 bits (i.e. using registers having 7 and 15 stages respectively). Other spectrally balanced sequences (including other lengths of p.r.b.s.) are also expected to work.

Whatever the choice of noise signal it should have a low autocorrelation over any time span which is of the same order of magnitude as the adaption time constant, typically a second. The pseudo-random bit sequence generator described has the advantage of being simple to implement and also is suitable for miniaturisation. It is noted however that it is a disadvantage of such a simple device, particularly when a low order pseudo-random bit sequence is employed, that it has a low repetition period. This can be a problem when the ambient acoustic signal is highly periodic - for example a long duration constant frequency sine wave signal. Spurious correlations with the injected signal may then occur and cause the adaption process to wander, leading to undesirable audible effects. These effects can be eliminated by providing a further randomisation of the pseudo-random bit sequence. This is shown for example in Fig. 9 where the signal at the output of the p.r.b.s. generator 103, 105 is gated by a second exclusive OR-gate 107 whose other input is connected to a source 109 of a randomising binary signal, for example it may be connected to the least significant digital output of the analogue digital converter 17 of the hearing aid. This has the effect of randomising the bit sequence further, and thus of eliminating the wandering effect.

It will be noted that by reducing cancellation of feedback over a broad range of frequencies, not just a small range of frequencies where oscillation can occur, all of the effects of the acoustic feedback can be removed. Thus it would be normally ensured that the noise signal has a flat level characteristic over the range 300 Hz to 7 kHz, the conventional bandwidth of a hearing aid.

Where only avoidance of oscillation is requisite however a noise signal having a flat spectral characteristic over a more limited range covering the expected range of oscillation frequencies normally would be adequate.

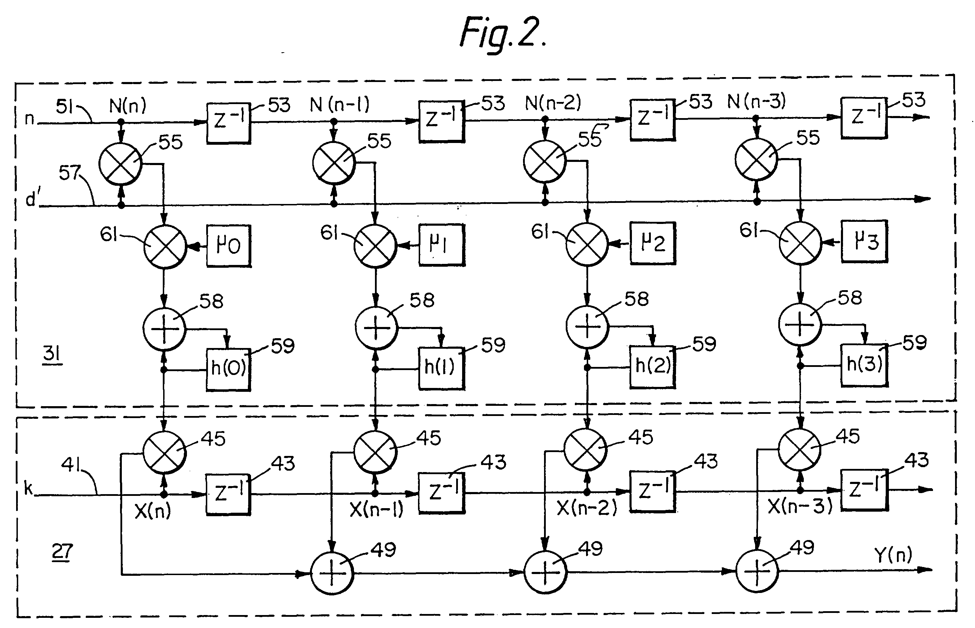

The correlator 31 and FIR filter 27 are shown in more detail in Fig. 2

The FIR filter 27 is of standard digital filter architecture. It comprises thus: a delay line 41 having a number of delay stages 43; a first requisite. The common circuit design may then be implemented. It is noted that although the higher clock frequency of 20 kHz could also be used for the BTE aid, by using a lower sample rate advantage is taken of the fact that the correlation is performed over a greater time span for a given number of delay stages. Thus performance can be improved or alternatively a similar performance achieved using a smaller number of correlator stages. The signal samples are individually multiplied by a series of multiplicative coefficients h(0), h(1), h(2) ...., etc, and the resulting products are summed by the digital adder 49 to produce a single output y (n). This operation is summarized by the formula:

$$y(n) = \sum_{m=0}^{N-1} \{ h(m) * x(n-m) \}$$

In this arrangement each of the coefficients h (m) is updated on each cycle of the master clock and a new output y (n) is calculated.

Adaption operates by adjusting the values of the multiplier 45 preceding the first one of the delay stages 43 and a multiplier 45 following each delay stage. The multipliers 45 are all connected in parallel to the input of a digital adder 49.

The input signal on digital lines k of the output of the delay line 29 is passed through the series of delay stages 43 to provide a series of sequential samples x (n), x (n-1), x (n-2) .... etc where x (n) is the most recent digital sample of the signal. Each sample is delayed one period of the master clock operating the analogue-to-digital converter 17 and the digital-to-analogue converter 19. Typically, for an in-the-ear aid (ITE) the upper band limit would be designed to be on the order of 7 kHz. For this the master clock frequency would need to be at least 14 kHz (Nyquist) and in practice a frequency of at least 20 kHz would be chosen. For a behind-the-ear aid the band width would be in any case somewhat lower since the communicative tubing used in its construction acts as a low pass filter. In such case a lower master clock frequency of say 10 kHz would then be more appropriate. A master clock oscillator including a switched capacitor filter could be used and could be preset to provide a master clock frequency of either 10 kHz or 20 kHz as is connected to tap 39 so as to receive the residual signal. The output of each multiplier 55 passes to an adaptation rate scale factor multiplier 61 and the product term is either added, by an adder 58, to an accumulated coefficient held in an accumulator register 59. The amplitude of this added term differs from the amplitude of the residual signal by an adaption-rate scale factor. The sign of this term, i.e. whether it is added or subtracted, depends upon the signs of the noise and residual signal being the same or different respectively.

The process is simplified by combining the long term averaging that is required for correlation into the coefficient accumulators. This is realised by extending the resolution of the coefficient accumulators 58-59, so that several successive correlation inputs are required before the accumulated input becomes significant to the filter 27. Thus in the construction shown each coefficient accumulator 59 is 24 bits in length of which only the most significant 12 to 14 bits are used to define the multiplicative coefficients h(m) used in the FIR filter 27. The ratio of maximum correlator input to filter significance determines the adaption rate. It is a property of the chosen adaption algorithm coefficients h(m) in a controlled manner. A correlator 31 designed to do this is also shown in Fig. 2. This correlator 31 is designed to adapt the filter 27 according to the Widrow-Hoff algorithm (see B. Widrow et al., "Stationary and non-stationary learning characteristics of the LMS adaptive filter," Proc. IEEE Volume 24 pages 1151 - 1162, August 1976). In applying this algorithm each coefficient h(m) is adjusted every cycle. The adjustment is a simple increase or decrease in the value of the coefficient h(m) the magnitude and the sign of which are determined by the action of the correlator. Each coefficient h(m) is accumulated independently.

The correlator 31 comprises a delay line 51 having a number of single bit delay stages 53. The number of these stages is the same as the number of stages 43 incorporated in the FIR filter 27 just described. The input to the delay line 51 and the output from each of the single bit delay stages 53 is connected to the reference input of a corresponding digital multiplier 55. The second input to each of the digital multipliers 55 is connected to a common set of digital lines 57. The delay line 51 is connected to receive noise signal N from the noise source 33 and delay line 37, whilst the common set of lines 57 described above that the adaption will vary as a function of signal level. In this preferred arrangement the adaption is continuous since the multiplicative coefficients are updated upon each master clock cycle. The adaption rate should therefore be carefully chosen to get an acceptable compromise between the rate of adaption from cold (or following an abrupt change in sound signal or in ambient conditions) and the degree of convergence (i.e. stability of the system) when after a settling period the conditions are stable. It is a drawback of the correlator thus far described that when it is designed to optimise the degree of convergence, i.e. long term stability, the settling period from start up can be somewhat excessive. As an improvement therefore a modification is provided to impose additional variation of the adaption rate. Thus in Fig. 2 the correlator 31 is modified by the insertion of a second multiplier in each stage between the first multiplier 55 and the corresponding coefficient accumulator 59. Each second multiplier 61 has an input to receive a scaling coefficient μ. The signed residual signal produced at the output of each first multiplier 55 is thus scaled by a multiplicative factor μ before it is passed on to the corresponding coefficient accumulator 59 for each consecutive stage of the correlator 31. Various techniques are thus possible to optimise the above trade-off between rate of adaption from cold (or an abrupt change in conditions) and the degree of convergence when conditions are stable. The preferred implementation thus uses an imposed variable rate of adaption. In practice it has thus been found that better performance is achieved by imposing a high rate of adaption when the hearing aid and thus correlator 31 are first switched on (i.e. from cold) followed by a lower imposed rate of adaption after a predetermined settling period, the latter for achieving long term stability. To implement this the multiplicative scaling coefficients μ are first assigned a common high value and after a predetermined settling time the coefficients μ are abruptly changed to a common second lower scaling value. Circuit components for generating the scaling coefficients μ thus may include a time measuring detector e.g. a counter that is triggered by the master clock. This then will accommodate the need for rapid adjustment of the multiplicative coefficients μ that are fed to the FIR filter 27 immediately following start-up. In order to accommodate not only rapid adjustment of the coefficients h(m) following start up but also rapid adjustment of the coefficients h(m) following an abrupt change in conditions long after start up, the counter could instead be triggered using a discriminator that is responsive to the level of the residual signal. Such implementations have proved to be altogether quite adequate. In the foregoing modification to the correlator 31 the scaling coefficients μ are changed step-wise between two values, a high value and a low value respectively. Other techniques of optimisation however are not precluded. In a more complex variant using an alternative design of counter the scaling coefficients may be changed from a high value to a low value by gradual transition through a series of decreasing values. In both the foregoing modifications discussed the scaling coefficients μ for each of the stages of the correlator 31 are changed in unison. It is also noted that when conditions are very stable no adaption would be required and updating of the accumulated coefficients could be inhibited by setting the scaling coefficients μ to zero for all stages of the correlator 1.

Instead of the foregoing, the adaption rate could be varied by changing the level of the injected noise. This may be implemented, for example, by controlling the level of the injected noise to vary as a function of the level of the audio signal. Provided that this is done keeping the ratio of signal to noise more or less constant, the net noise output whilst audible would be quite unobtrusive. Further details will be given below.

The embodiment and its variants described above may be implemented as part of the internal circuitry of a hearing aid. The Widrow-Hoff algorithm is highly efficient. The circuitry therefore is particularly appropriate to the construction of "behind-the-ear" "in-the-ear" and "in-the-canal" aids where low power operation is required.

The limiter 15 described above is, in accordance with the present invention, located as shown in Fig. 1 between the correlation tapping point 39 and the noise insertion node 21. This position is optimum. By way of comparison, it is noted that it could be located at other positions between the feedback insertion node 23 and the feedback tapping point 25. These alternative two positions are shown in figs. 6 and 7. In Fig. 6 it is shown located between the feedback signal injection summing node 23 and the correlator input tap 39. For this location however signal clipping results in a loss of information about the noise that has been added and this results in a slow down of the adaption. Similarly when the limiter is located between the noise injection summing node 21 and the feedback input tap 25 the injected noise is limited and again the adaption is slowed down.

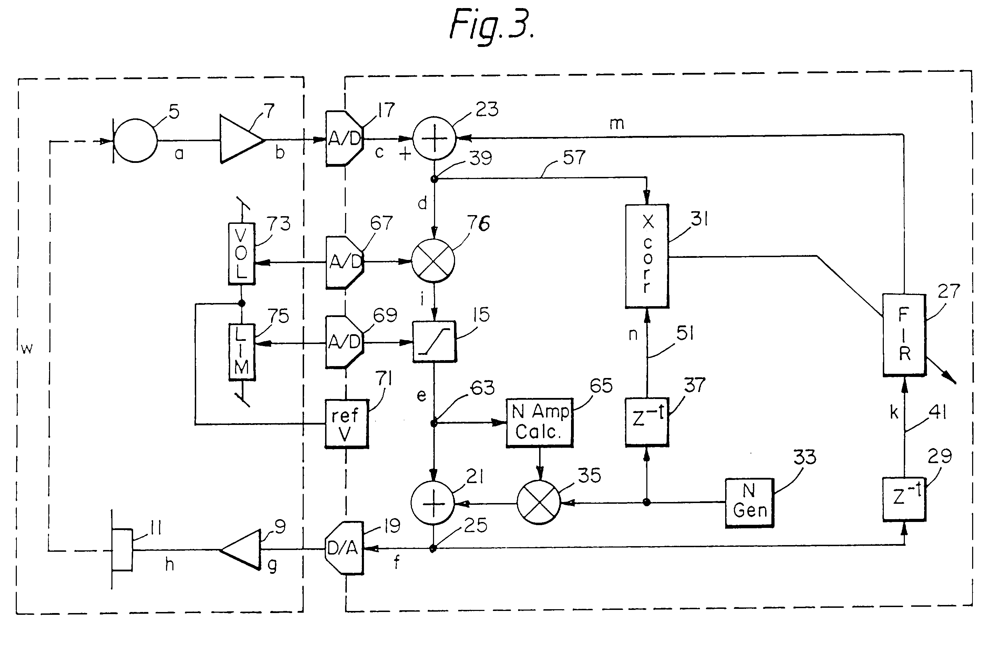

Further refinements of this hearing aid are shown in Fig. 3. This refined embodiment includes a user controlled volume control and also provides for external variation of the limitation levels for the limiter. Provision is also made for signal to noise level control and also for preset adjustment by the user.

In a practical hearing aid it is desirable to have a volume control which can be user controlled. This can be placed in the microphone amplifier or before the output amplifier, but in both cases the adaptive filter must change its coefficients when the volume control is adjusted. If however the volume control is placed after the subtraction of the anti-feedback signal and before the limiter neither the maximum output nor the coefficients need to change when the volume control is adjusted. In the adapted arrangement shown in Fig. 3 a multiplier 76, is inserted between the correlator input tap 39 and the limiter 15. The control for the multiplier 76 is provided by a user controlled volume control potentiometer 73 and an A/D converter 67.

The limits for the limiter 15 could also be user controlled. This is desirable because the limiter determines the maximum sound pressure level which is able to occur in the user's ear. This is a significant feature because the maximum output can be reduced or altered without reducing or altering the gain of the amplifiers. As shown in Fig. 3 the maximum positive and negative limits 93, 95 for the limiter 15 are provided by a user controlled potentiometer 75 and an A/D converter 69. In the simple arrangement shown, the volume control and limit control potentiometers 73, 75 are connected to a common source 71 of a reference voltage.

One or more filters would normally be included to modify the spectral response according to prescriptive requirements. Preferably in the hearing aid circuit shown in either Figs. 1 or 3 this is implemented digitally using one or more FIR or IIR filters. It is preferable to locate such a filter or filters between the limiter 15 and the feedback cancellation signal node 23. Such filters would usually introduce added delay, but if placed in this preferred location it is not necessary to add extra delays in the feedback cancellation loop. This would be necessary if the filter were placed to immediately precede the digital to analogue converter 19.

Due to the limited length of the feedback cancellation FIR filter used in the embodiments described, the possible cancellation grows with the frequency, and is therefore most effective in hearing aids with a relative high gain at the higher frequencies. With some kinds of hearing loss it is desirable to reduce the high frequency gain, because the user's residual hearing at loss of frequencies is useless. Inevitably this kind of filtering will reduce the effect of feedback cancellation. A solution is to reduce the sampling frequency. This requires however that the anti-aliasing filter cutoff frequency tracks the sampling frequency. This could be done with a switched capacitor filter coupled to the A/D converters 17, 67 and 69.

As already mentioned above the noise level may be controlled to provide optimal rates of adaption. As shown in Fig. 3 the multiplier 35 following the noise generator 33 is controlled by a computational unit 65. This may have the form of a single stage recursive filter such as that shown in Fig. 10. The input to this computational unit 65 is taken from a point 63 in the main path between the correlator input at 39 and the noise injection node 21. The computational unit 65 outputs a multiplier value that is dependent on the signal level measured at point 63 and is chosen such that the sum of the wanted signal coming from the limiter 15 and the added noise signal do not exceed the saturation level of any of the components that follow, specifically the summing node adder 21, the digital to analogue converter 19, the main amplifier 9 and the receiver transducer 11. The first order recursive filter 65 shown in Fig. 10 comprises a first unit 111 for measuring the absolute signal level. This is followed by a first multiplier 113 which produces at its output a signal that is one sixteenth of original level. This then is added by an adder 115 to a signal that has been delayed one cycle by a delay element 117 and scaled by fifteen sixteenths by a second multiplier 119. The output of this part of the first order recursive filter is then scaled by a preset factor of between one quarter and one sixteenth. The value of this preset scale multiplier may be fixed during manufacture or alternatively may be arranged to be preset by the user during initial set up. Accordingly the noise level can be preset to accomodate a user having either a poor or moderate hearing loss as appropriate.

By cancelling all of the effects of acoustic feedback and not simply inhibiting the onset and occurrence of oscillation, this new technique offers several user benefits:

    (i) Inhibition of oscillatory (unstable) response;

(ii) Avoidance of perceivable "ringing effects" noticable at gain settings just below those that cause oscillation;

(iii) Removal of gain-dependent perturbations in the frequency response which occur at frequencies far removed from the usual oscillation frequency.

As applied to hearing aids, the invention is intended to allow choice of a wider range of fittings. In particular it is intended to extend the range of availability of vented aids i.e. to allow such aids, particularly those having large diameter vents, to be prescribed where high gain is required in the higher range of audio frequencies.

## Claims

1. A hearing aid comprising:

a microphone (5) to receive an acoustic signal and to output a corresponding electrical signal; an electrical main pathway (a to h) connected between said microphone and a receiver (11), said electrical main pathway (a to h) having a correlation tapping point (39), and also, in the following order, a feedback insertion node (23), a noise insertion node (21), and a feedback tapping point (25); a preamplifier (7) arranged in said electrical main pathway (a to h), between said microphone (5) and said feedback insertion node (23), to receive the electrical signal output by said microphone (5), to output a preamplified signal; a main amplifier (9) arranged in said electrical main pathway (a to h), between said feedback tapping point (25) and the receiver (11), to receive the electrical main pathway signal and to output an amplified signal; said receiver (11), connected to said electrical main pathway (a to h) to receive the amplified signal and to output a corresponding acoustic signal; an electrical negative feedback pathway (k,m), connected across said electrical main pathway (a to h), between said feedback tapping point (25) and said feedback insertion node (23); an adaptive electrical filter (27), arranged in said electrical negative feedback pathway (k, m), said adaptive electrical filter having characteristics which are calculated to model acoustic coupling between said receiver (11) and said microphone (5), whereby an electrical feedback signal is derivable by extracting, from said feedback tapping point (25), an electrical signal from said electrical main pathway (a to h) and passing the extracted signal through said adaptive electrical filter (27), and the derived electrical feedback signal when injected, at said feedback insertion node (23), into said electrical main pathway (a to h) compensates for the acoustic coupling; a noise source (33), connected to said noise insertion node (21), to inject continuously, a noise signal into said main amplifier (9); and adaption control means (31) having a first input (d') connected to said correlation tapping point (39), a second input (n) connected to said noise source (33), to receive a noise signal therefrom, and an output connected to a control input of said adaptive electrical filter (27), for correlating the electrical main pathway signal and the noise signal input thereto from said electrical main pathway and from said noise source (33), respectively, to adjust adaptively said adaptive electrical filter (27);

characterised in that:

said correlation tapping point (39) is located in said electrical main pathway between said feedback insertion node (23) and said noise insertion node (21); and an amplitude limiter (15) is located in said electrical main pathway (a to h) between said correlation tapping point (39) and said noise insertion node (21), which amplitude limiter (15) is arranged to restrict the positive and negative amplitude excursions of the electrical main pathway signal, applied at its input, to predetermined positive and negative amplitude limit values such that at all times the linearity limits of said main amplifier (9) and said receiver (11) are not exceeded.

2. A hearing aid according to claim 1 wherein said amplitude limiter (15) is a limiter having means of adjustment (93,95) for adjusting said positive and negative amplitude limit values thereof.

3. A hearing aid according to claim 2, wherein said means of adjustment (93,95) includes means for external adjustment (69,75).

4. A hearing aid, according to any of claims 1 to 3, wherein said preamplifier (7) is followed by an analog to digital converter (17);

said main amplifier (9) is preceded by a digital to analog converter (19); and said noise source (33), said amplitude limiter (15) and said adaptive electrical filter (27) are all digital.

**5.** A hearing aid, according to claim 4, wherein said adaptive electrical filter (27) comprises a finite impulse response filter (27).

**6.** A hearing aid according to claim 5 wherein said adaption control means (31) comprises:

a delay line (51), connected to the second input (n) of said adaption control means (31), which delay line (51) is formed of a plurality of single bit delay stages (53) arranged in series; a plurality of digital multipliers (55) each having a reference input and a second input, wherein the second input (n) of said adaption control means (31) is connected to the reference input of one of said digital multipliers (55) and the output from each respective single bit delay stage (53) is connected to the reference input of a respective corresponding other one of said digital multipliers (55), and said second input of each one of said plurality of digital multipliers (55) is connected to said first input (d') of said adaption control means (31); a plurality of adaption rate scale factor multipliers (61), each one having its input connected to the output of a respective one of said digital multipliers (55); a plurality of adders (58), each one having a first input and a second input, wherein the first input thereof is connected to the output of a respective one of said adaption rate scale factor multipliers (61); a plurality of accumulator registers (59), each one connected to the respective output and the second input of a respective one of said adders (58); and scaling coefficient supply means for supplying scaling coefficients (μo,μ1,...) to said adaption rate scale factor multipliers (61) to adjust the adaption rate of said adaptive electrical filter (27).

**7.** A hearing aid according to claim 5 including a multiplier (35) connected between said noise source (33) and said noise insertion node (21) for adjusting the level of the noise signal injected into said receiver (11) via said noise insertion node (21), as a means of adjusting the adaption rate of said adaptive electrical filter (27).

**8.** A hearing aid according to claim 7 including:
a computational unit (65) connected to a connection point (63) of said electrical main pathway (a to h) located between said correlation tapping point (39) and said noise insertion node (21), to output, to said multiplier (35), a multiplier value that is dependent on the level of the signal at said connection point, and that is such that the sum of the noise signal, output by said multiplier (35), and the signal output by said amplitude limiter (15) does not exceed the saturation levels of said noise insertion node (21) and said digital-to-analogue converter (19).

**9.** A hearing aid according to claim 8 wherein said computational unit (65) is a first order recursive filter.

**10.** A hearing aid, according to any preceding claim, wherein the noise source (33) comprises a pseudo-random-binary-sequence signal generator (103,105).

**11.** A hearing aid according to claim 6 wherein said noise source (33) comprises:

a pseudo-random-binary-sequence signal generator (103,105); and an exclusive OR-gate (107) connected at one input to the output of said pseudo-random-binary-sequence signal generator (103,105) and connected at its other input to the least significant digital output of said analog to digital converter (17) for producing a randomised pseudo-random-binary-sequence noise signal.

**12.** A hearing aid according to any preceding claim including manual volume control means (73,67,76) located between said amplitude limiter (15) and said feedback insertion node (23).

**13.** A hearing aid, according to any preceding claim including a vented moulding configured to fit in the ear.

**Patentansprüche**

**1.** Hörgerät, umfassend:

ein Mikrofon (5) zum Empfangen eines akustischen Signals und zum Ausgeben eines entsprechenden elektrischen Signals; einen elektrischen Hauptpfad (a bis h), der das Mikrofon und einen Empfänger (11) verbindet, wobei der elektrische Hauptpfad einen elektrischen Korrelations-Abgreifpunkt (39) und außerdem in der nachfolgenden Reihenfolge einen Rückkopplungseinfügungs-Knotenpunkt (23), einen Geräuscheinfügungs-Knotenpunkt (21) und einen Rückkopplungs-Abgreifpunkt (25) aufweist; einen in dem elektrischen Hauptpfad (a bis h) zwischen dem Mikrofon (5) und dem Rückkopplungseinfügungs-Knotenpunkt (25) angeordneten Vorverstärker (7) zum Empfangen des von dem Mikrofon (5) ausgegebenen elektrischen Signals und zum Ausgeben eines vorverstärkten Signals;

einen in dem elektrischen Hauptpfad (a bis h) zwischen dem Rückkopplungs-Abgreifpunkt (25) und dem Empfänger (11) angeordneten Hauptverstärker (9) zum Empfangen des elektrischen Hauptpfadsignals und zum Ausgeben eines verstärkten Signals;

wobei der Empfänger (11) mit dem elektrischen Hauptpfad (a bis h) verbunden ist, um das verstärkte Signal zu empfangen und ein entsprechendes akustisches Signal auszugeben;

einen elektrischen Gegenkopplungspfad (Negativ-Rückkopplungspfad) (k, m), der zwischen dem RückkopplungsAbgreifpunkt (25) und dem Rückkopplungseinfügungs-Knotenpunkt (23) parallel zu dem elektrischen Hauptpfad (a bis h) geschaltet ist;

ein in dem elektrischen Gegenkopplungspfad (k, m) angeordnetes elektrisches Adaptivfilter (selbstanpassendes elektrisches Filter) (27) mit Kennwerten, die auf eine modell-akustische Kopplung zwischen dem Empfänger (11) und dem Mikrofon (5) berechnet werden, wobei ein elektrisches Rückkopplungssignal durch Extrahieren von dem Rückkopplungs-Abgreifpunkt (25) ableitbar ist und ein elektrisches Signal von dem elektrischen Hauptpfad (a bis h), und das extrahierte Signal durch das elektrische Adaptivfilter (27) hindurchgeht und das abgeleitete elektrische Rückkopplungssignal beim Eingeben am Rückkopplungseinfügungs-Knotenpunkt (23) in den elektrischen Hauptpfad (a bis h) die akustische Kopplung kompensiert;

eine mit dem Geräuscheinfügungs-Knotenpunkt (21) verbundene Geräuschquelle (33) zum kontinuierlichen Eingeben eines Geräuschsignals in den Hauptverstärker (9);

Adaptionssteuermittel (31) mit einem ersten Eingang (d'), der an den Korrelations-Abgreifpunkt (39) angeschlossen ist, einem zweiten Eingang (n), der mit der Geräuschquelle (33) verbunden ist, um ein Geräuschsignal von dieser aufzunehmen, und einem Ausgang, der mit einem Steuerungseingang des elektrischen Adaptivfilters (27) verbunden ist, zum Korrelieren des elektrischen Hauptpfadsignals und der Geräuschsignaleingabe in dieses vom elektrischen Hauptpfad und von der Geräuschquelle (33) bzw. zum adaptiven Einstellen des elektrischen Adaptivfilters (27),

dadurch gekennzeichnet, daß der Korrelations-Abgreifpunkt (39) in dem elektrischen Hauptpfad zwischen dem Rückkopplungseinfügungs-Knotenpunkt (23) und dem Geräuscheinfügungs-Knotenpunkt (21) angeordnet ist; und in dem elektrischen Hauptpfad (a bis h) zwischen dem Korrelations-Abgreifpunkt (39) und dem Geräuscheinfügungs-Knotenpunkt (21) ein Amplitudenbegrenzer (15) vorgesehen ist, der zur Begrenzung der an seinen Eingang angelegten positiven und negativen Amplitudenauslenkungen des elektrischen Hauptpfadsignals angeordnet ist, und zwar auf vorbestimmte positive und negative Amplitudengrenzwerte, derart, daß zu jeder Zeit die Linearitätsgrenzwerte des Hauptverstärkers (9)und des Empfängers (11) nicht überschritten werden.

2. Hörgerät nach Anspruch 1, dadurch gekennzeichnet, daß der Amplitudenbegrenzer (15) Einstellmittel (93, 95) zum Einstellen seiner positiven und negativen Amplitudengrenzwerte aufweist.

3. Hörgerät nach Anspruch 2, dadurch gekennzeichnet, daß die Einstellmittel (93, 95) Mittel zur externen Einstellung (69, 75) einschließen.

4. Hörgerät nach einem der Ansprüche 1 bis 3, dadurch gekennzeichnet, daß auf den Vorverstärker (7) ein Analog-Digital-Umsetzer (17) folgt;

dem Hauptverstärker (9) ein Digital-Analog-Umsetzer (19) vorgeschaltet ist; und die Geräuschquelle (33), der Amplitudenbegrenzer (15) und das elektrische Adaptivfilter (27) sämtlich digital ausgebildet sind.

5. Hörgerät nach Anspruch 4, dadurch gekennzeichnet, daß das elektrische Adaptivfilter (27) ein begrenztes Impulsansprechfilter (27) umfaßt.

6. Hörgerät nach Anspruch 5, dadurch gekennzeichnet, daß das Adaptionsregelungsmittel (31) umfaßt:

eine mit dem zweiten Eingang (n) des Adaptionsregelungsmittels (31) verbundene Verzögerungsleitung (51), die aus einer Mehrzahl Einbit-Verzögerungsstufen, die in Reihe angeordnet sind, gebildet ist; eine Mehrzahl digitaler Vervielfacher (55) mit jeweils einem Referenzeingang und einem zweiten Eingang, wobei der zweite Eingang (n) des Adaptionsregelungsmittels (31) mit dem Referenzeingang von einem der digitalen Vervielfacher (55) verbunden ist und der Ausgang von der jeweiligen Einbit-Verzögerungsstufe (53) an den Referenzeingang des jeweils entsprechenden anderen digitalen Vervielfachers (55) angeschlossen ist, und der zweite Eingang von jedem einzelnen der Mehrzahl der digitalen Vervielfacher (55) an den ersten Eingang (d') des Adaptionsregelungsmittels (31) angeschlossen ist;

eine Mehrzahl Adaptionsgeschwindigkeits-Normierungsfaktor-Vervielfacher (61), deren Eingang jeweils an den Ausgang des jeweils einen der digitalen Vervielfacher (55) angeschlossen ist;

eine Mehrzahl Addierer (58), von denen jeder einen erst Eingang und einen zweiten Eingang aufweist, wobei deren erster Eingang an den Ausgang von jeweils einem der Adaptions-Normierungsfaktor-Vervielfacher (61) angeschlossen ist;

eine Mehrzahl Akkumulatorregister (59), von denen jedes mit dem jeweiligen Ausgang und dem jeweiligen zweiten Eingang von jeweils einem der Addierer (58) verbunden ist; und

Normierungskoeffizient-Zuführungsmittel zur Lieferung der Normierungskoeffizienten ($\mu_0$, $\mu_1$ ...) zum Adaptionsgeschwindigkeits-Normierungsfaktor-Vervielfacher (61) zur Einstellunq der Adaptionsgeschwindigkeit des elektrischen Adaptivfilters (27).

7. Hörgerät nach Anspruch 5, dadurch gekennzeichnet, daß es einen zwischen die Geräuschquelle (33) und den Geräuscheinfügungs-Knotenpunkt (21) geschalteten Vervielfacher (35) zum Einstellen des Pegels des Geräuschsignals, das in den Empfänger (11) über den Geräuscheinfügungs-Knotenpunkt (21) eingegeben wird, einschließt, und zwar als Mittel zum Einstellen der Adaptionsgeschwindigkeit des elektrischen Adaptivfilters (27).

8. Hörgerät nach Anspruch 7, dadurch gekennzeichnet, daß es eine Berechnungseinheit (65) umfaßt, die mit einem Anschlußpunkt (63) des elektrischen Hauptpfades (a bis h) verbunden ist, der zwischen dem Korrelations-Abgreifpunkt (39) und dem Geräuscheinfügungs-Knotenpunkt (21) angeordnet ist, um zu dem Vervielfacher (35) einen Vervielfacherwert auszugeben, der von dem Pegel des Signals an dem Verbindungspunkt abhängig ist und von der Art ist, daß die Summe aus dem von dem Vervielfacher (35) ausgegebenen Geräuschsignal und dem von dem Amplitudenbegrenzer (15) ausgegebenen Signal das Sättigungsniveau des Geräuscheinfügungs-Knotenpunktes (21) und des Digital-Analog-Umsetzers (19) nicht überschreitet.

9. Hörgerät nach Anspruch 8, dadurch gekennzeichnet, daß die Berechnungseinheit (65) ein Rekursivfilter erster Ordnung ist.

10. Hörgerät nach einem der vorhergehenden Ansprüche, dadurch gekennzeichnet, daß die Geräuschquelle (33) ein Pseudozufalls-Binärsequenz-Signalerzeuger (103, 105) ist.

11. Hörgerät nach Anspruch 6, dadurch gekennzeichnet, daß die Geräuschquelle (33) einen Pseudozufalls-Binärsequenz-Signalerzeuger (103, 105) und ein Exclusiv-Oder-Glied (107) umfaßt, das an einem Eingang an den Ausgang des Pseudozufalls-Binärsequenz-Signalerzeugers (103, 105) angeschlossen ist und an seinem anderen Eingang mit dem letzten signifikanten digitalen Ausgang des Analog-Digital-Umsetzers (17) verbunden ist, und zwar zur Erzeugung eines auf eine Zufallszahl umgerechneten Pseudozufalls-Binärsequenz-Geräuschsignals.

12. Hörgerät nach einem der vorhergehenden Ansprüche, dadurch gekennzeichnet, daß es eine manuelle Lautstärke-Regelvorrichtung (73, 67, 76) umfaßt, die sich zwischen dem Amplitudenbegrenzer (15) und dem Rückkopplungseinfügungs-Knotenpunkt (23) befindet.

13. Hörgerät nach einem der vorhergehenden Ansprüche, dadurch gekennzeichnet, daß es ein ventiliertes Formteil einschließt, das passend für das Ohr ausgebildet ist.

**Revendications**

1. Une prothèse auditive comprenant :

un microphone (5) pour recevoir un signal acoustique et pour fournir en sortie un signal électrique correspondant ;
un circuit électrique principal (a à h) relié entre ledit microphone et un récepteur (11), ledit circuit électrique principal (a à h) présentant un point de dérivation de corrélation (39), et également, dans l'ordre suivant : un noeud d'insertion d'un signal de rétroaction (23), un noeud d'insertion de bruit (21), et un point de prélèvement d'un signal de rétroaction (25) ;
un préamplificateur (7) agencé dans ledit circuit électrique principal (a à h), entre ledit microphone (5) et ledit noeud d'insertion d'un signal de rétroaction (23), pour recevoir le signal électrique fourni en sortie par ledit microphone (5), pour fournir en sortie un signal préamplifié ;
un amplificateur principal (9) agencé dans ledit circuit électrique principal (a à h), entre ledit point de prélèvement de signal de rétroaction (25) et le récepteur (11), pour recevoir le signal du circuit électrique principal et pour fournir en sortie un signal amplifié ;
ledit récepteur (11), relié audit circuit électrique principal (a à h) pour recevoir le signal amplifié et pour fournir en sortie un signal acoustique correspondant ;
un circuit pour un signal électrique négatif de rétroaction (k, m) relié via ledit circuit électrique principal (a à h) entre ledit point de prélèvement d'un signal de rétroaction (25) et ledit noeud d'insertion d'un signal de rétroaction (23) dudit circuit électrique principal (a à h) ;

un filtre électrique adaptatif (27), agencé dans ledit circuit d'un signal électrique de rétroaction (k, m), ledit filtre électrique adaptatif présentant des caractéristiques qui sont calculées pour modéliser le couplage acoustique entre ledit récepteur (1l) et ledit microphone (5), de façon à pouvoir dériver un signal de rétroaction électrique par extraction, au niveau dudit point de prélèvement d'un signal de rétroaction (25), d'un signal électrique à partir dudit circuit électrique principal (a à h) et en faisant passer le signal extrait à travers ledit filtre électrique adaptatif (27), et le signal de rétroaction électrique dérivé injecté dans ledit circuit électrique principal (a à h), au niveau dudit noeud d'insertion du signal de rétroaction (23), en réalisant la compensation du couplage acoustique ;

une source de bruit (33), reliée audit noeud d'insertion de bruit (21), pour injecter en continu un signal de bruit dans ledit amplificateur principal (9) ; et

des moyens de commande d'adaptation (31) présentant une première entrée (d') reliée audit point de dérivation de corrélation (39), une deuxième entrée (n) reliée à ladite source de bruit (33), pour recevoir à partir de ce dernier un signal de bruit, et une sortie reliée à une entrée de commande dudit filtre électrique adaptatif (27) pour réaliser une corrélation respectivement entre, d'une part, le signal du circuit électrique principal et, d'autre part, le signal de bruit fourni en entrée à partir du circuit électrique principal et, à partir de ladite source de bruit (33), pour régler de façon adaptative ledit filtre électrique adaptatif (27) ;

caractérisé en ce que :

ledit point de prélèvement de corrélation (39) est situé sur ledit circuit électrique principal entre ledit noeud d'insertion d'un signal de rétroaction (23) et ledit noeud d'insertion de bruit (21) ; et en ce que

un limiteur d'amplitude (15) est situé sur ledit circuit électrique principal (a à h) entre ledit point de dérivation de corrélation (39) et ledit noeud d'insertion de bruit (21), ce limiteur d'amplitude (15) étant agencé pour limiter les excursions d'amplitude positive et négative du signal du circuit électrique principal, appliqué à son entrée, au niveau de valeurs de limitation d'amplitude positives et négatives prédéterminées, de telle sorte que, à tous moments, les limites de linéarité dudit amplificateur principal (9) et dudit récepteur (11) ne soient pas dépassées.

2. Une prothèse auditive selon la revendication 1, dans laquelle ledit limiteur d'amplitude (15) est un limiteur présentant des moyens de réglage (93, 95) pour régler lesdites valeurs limite d'amplitude positives et négatives.

3. Une prothèse auditive selon la revendication 2, dans laquelle lesdits moyens de réglage (93, 95) comprennent des moyens de réglage externes (69, 75).

4. Une prothèse auditive, selon l'une quelconque des revendications 1 à 3, dans laquelle ledit préamplificateur (7) est suivi d'un convertisseur analogique/numérique (17) ;

ledit amplificateur principal (9) est précédé d'un convertisseur numérique/analogique (19) ; et ladite source de bruit (33), ledit limiteur d'amplitude (15) et ledit filtre électrique adaptatif (27) sont tous numériques.

5. Une prothèse auditive selon la revendication 4, dans laquelle ledit filtre électrique adaptatif (27) comprend un filtre à réponse impulsionnelle finie (27).

6. Une prothèse auditive selon la revendication 5, dans laquelle lesdits moyens de commande d'adaptation (31) comprennent :

une ligne de retard (51), reliée à la deuxième entrée (n) desdits moyens de commande d'adaptation (31), cette ligne de retard (51) étant constituée d'une pluralité d'étages de retard à un seul bit (53) agencés en séries ;

une pluralité de multiplicateurs numériques (55) présentant chacun une entrée de référence et une deuxième entrée, dans lesquels la deuxième entrée (n) desdits moyens de commande d'adaptation (31) est reliée à l'entrée de référence d'un parmi lesdits multiplicateurs numériques (55) et la sortie de chaque étage respectif de retard à un seul bit (53) est reliée à l'entrée de référence d'un multiplicateur numérique respectif correspondant, parmi les autres multiplicateurs numériques (55), et ladite deuxième entrée de chacun parmi ladite pluralité de multiplicateurs numériques (55) étant reliée à ladite première entrée (d') desdits moyens de commande d'adaptation (31) ;

une pluralité de multiplicateurs de facteur d'échelle du taux d'adaptation (61), présentant chacun son entrée reliée à la sortie de l'un respectif desdits multiplicateurs numériques (55) correspondants ;

une pluralité d'additionneurs (58), présentant chacun une première entrée et une deuxième entrée, dans lesquels la première entrée est reliée à la sortie de l'un respectif desdits multiplicateurs du facteur d'échelle du taux d'adaptation (61) ;

une pluralité de registres à accumulation (59), relié chacun à la sortie respective et à la deuxième entrée de l'un respectif desdits additionneurs (58) ; et

des moyens fournissant des coefficients de mise à l'échelle pour fournir des coefficients de mise à l'échelle ($\mu 0$, $\mu 1$...) auxdits multiplicateurs de facteur d'échelle du taux d'adaptation (61) pour régler le taux d'adaptation dudit filtre électrique adaptatif (27).

7. Une prothèse auditive selon la revendication 5, comprenant un multiplicateur (35) relié entre ladite source de bruit (33) et ledit noeud d'insertion de bruit (21) pour régler le niveau du signal de bruit injecté dans ledit récepteur (11) via ledit noeud d'insertion de bruit (21), en tant que moyens permettant de régler le taux d'adaptation dudit filtre électrique adaptatif (27).

8. Une prothèse auditive selon la revendication 7, comprenant :

une unité de calcul (65) reliée à un point de connexion (63) dudit circuit électrique principal (a à h) situé entre ledit point de dérivation de corrélation (39) et ledit noeud d'insertion de bruit (21) pour fournir en sortie, vers ledit multiplicateur (35) une valeur de multiplicateur qui dépend du niveau du signal audit point de connexion, et qui est telle que la somme du signal de bruit, fourni en sortie par ledit multiplicateur (35) d'une part, et le signal fourni en sortie par ledit limiteur d'amplitude (15) d'autre part, ne dépasse pas les niveaux de saturation dudit noeud d'insertion de bruit (21) et ledit convertisseur numérique/analogique (19).

9. Une prothèse auditive selon la revendication 8, dans laquelle ladite unité de calcul (65) est un filtre récursif de premier ordre.

10. Une prothèse auditive selon l'une quelconque des revendications précédentes, dans laquelle la source de bruit (33) comprend un générateur de signaux de séquences binaires pseudo-aléatoires (103, 105).

11. Une prothèse auditive selon la revendication 6, dans laquelle ladite source de bruit (33) comprend :

un générateur de séquences binaires pseudo/aléatoires (103, 150) ; et

une porte OU exclusive (107) reliée, à l'une de ses entrées, à la sortie dudit générateur de séquences binaire pseudo/aléatoire (103, 105) et reliée à son autre entrée, à la sortie numérique de poids le plus faible dudit convertisseur analogique/numérique (17) pour fournir un signal de bruit aléatoire comprenant des séquences binaires pseudo/aléatoires.

12. Une prothèse auditive selon l'une quelconque des revendications précédentes, comprenant des moyens de réglage manuel de volume (73, 67, 76) situés entre ledit limiteur d'amplitude (15) et ledit noeud d'insertion d'un signal de rétraction (23).

13. Une prothèse auditive selon l'une quelconque des revendications précédentes, comprenant une pièce moulée munie d'un évent, qui présente une configuration propre à s'adapter à l'oreille.

Fig.1.

15

Fig.2.

EP 0 415 677 B1

Fig.3.

Fig.4.

Fig.5.

Fig.6.

Fig.7.

## Fig.8.

## Fig.9.

## Fig.10.